# EUROPEAN PATENT SPECIFICATION

(11) **EP 1 427 002 B1**
(45) Date of publication and mention of the grant of the patent: **12.04.2017**
(21) Application number: 02293044.0
(22) Date of filing: 06.12.2002
(51) Int. Cl.: H01L 21/304, H01L 21/762, H01L 21/263, H01L 21/306, B23K 26/066, B23K 26/16, B23K 26/38, B26F 3/00

(54) **A method for recycling a substrate using local cutting**
Verfahren zum Recyceln eines Substrats mittels lokalen Schneidens
Méthode de recyclage d'un substrat par découpage localisé

(43) Date of publication of application: 09.06.2004
(73) Proprietor: Soitec, 38190 Bernin (FR)
(72) Inventor: Letertre, Fabrice, 38000 Grenoble (FR); Maleville, Christophe, 38660 La Terasse (FR); Maurice, Thibaut, 38100 Grenoble (FR); Mazure, Carlos, 38330 St. Nazaire les Eymes (FR); Metral, Fredéric, 38210 St. Quantin sur Isère (FR)
(74) Representative: Grünecker Patent- und Rechtsanwälte PartG mbB

(56) References cited:
- EP-A- 0 955 671
- EP-A- 1 156 531
- WO-A-01/80308
- WO-A-98/52216
- WO-A2-03/063213

## Description

The present invention relates to a method for recycling a substrate, especially a wafer, said substrate having a profile with a surface and a collar, wherein an interface provided between said surface and said collar has been formed by a previous separation step.

In the semiconductor industry, recycling of used wafers for reuse has emerged, especially in recent years, as an acceptable way to substantially reduce million dollar budget outlays, in particular for test wafers. A wafer recycling process involves essentially three main steps: removing unwanted materials, polishing and cleansing

Chemical techniques for polishing involve the immersion of wafers in a series of chemical baths to strip film materials and etch the silicon. Mechanical techniques on the other hand, physically remove films and silicon by placing the wafer between two rotating metal plates and grinding away material by means of slurries. Because of the mechanical nature of conventional grinding, a deep damage layer is created on the wafer, requiring significant silicon removal in subsequent processing steps to recover the original wafer finish.

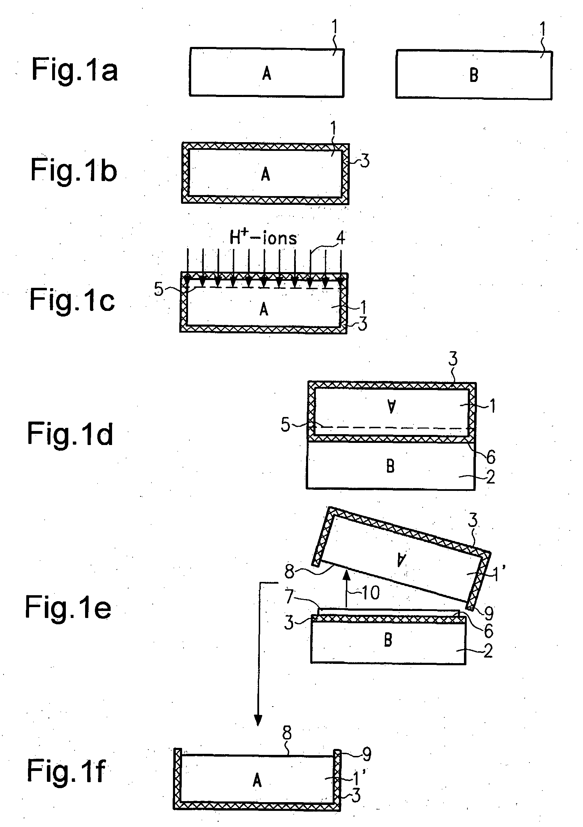

Wafer recycling plays a particularly important role in the so-called Smart-cut^{®} process, the principle of which is shown in Fig. 1. In this process, a first silicon wafer 1 is oxidised and implanted with gaseous species like hydrogen ions or gas ions 4. The implantation leads to the creation of a buried, weakened layer, comprising microcavities, platelets and/or microbubbles. Further, the wafer 1 is bonded with a second silicon wafer 2 and then separated by splitting into two wafer parts to a depth corresponding to the penetration depth 5 of the implanted species. In this way, a SOI (silicon on insulator) wafer containing the original second wafer 2 and a SOI layer 7 and a remaining delaminated wafer 1' being a part of the former wafer 1 are produced.

The delaminated wafer 1' has a certain profile including a relatively flat but damaged and rough surface 8 which is surrounded by a collar 9 on this surface. The collar 9 of the delaminated wafer 1' is formed in the Smart-cut^{®} process in which during bonding, the surfaces of both wafers 1, 2 are bonded except for an edge exclusion where the wafers are not flat. That part of the surface of the first wafer 1 which is bonded with the second wafer 2 is transferred onto the second wafer 2 during splitting. The edge exclusion which is not bonded is not transferred and forms the collar 9 of the delaminated wafer 1', resulting in a loss of material at the edge of the positive wafer containing the original wafer 2 and the SOI-layer 7 split from the first wafer 1. In order to make the separated delaminated wafer reusable, the non-uniform separation profile must be planarised.

As mentioned above, a chemical and/or mechanical polishing (CMP) can be used to remove material from such a delaminated wafer to obtain a uniform planarisation globally across the wafer. In EP 0 955 671 A1, for instance, a step in the peripheral part of a delaminated wafer is removed by a polishing step resulting in a stock removal of about 1 to 2 mu m. This recycling method has the disadvantage that relatively more material has to be removed from the wafer to get a reasonably acceptable value of the total thickness variation of the recycled wafer. Therefore, a wafer cannot be reused often. Due to the intensive treatment in the CMP process, there is an increased risk of the breaking of the wafer during its planarisation. EP 1 156 531 A1 describes a method for reclaiming a delaminated wafer.

EP 0 955 671 A1 describes a method for recycling a delaminated wafer of the above mentioned type in which the delaminated wafer surface is polished to remove about 1 mu m material from the surface and is then heat treated in a reducing atmosphere at a temperature between 1000 DEG C and the melting point of the wafer material for several hours. This thermal treatment represents a strong load on the treated wafer and expends a lot of energy and processing time.

It is the object of the present invention to provide an improved method of the above-mentioned type which allows a substrate to be reused more often without thermal treatment and enables the recycled substrate to be produced with a low total thickness variance wherein a good planar surface quality is obtained.

This object is solved with a method according to each one of claims 1, 3, 7 and 8.

In comparison to the prior art technique, this method treats the collar on the surface and uses the selective removal of the collar to obtain a plane surface. By the inventive method, the collar can be severed, preferably piecewise, from the semiconductor surface in a separate step so that the collar can be cut off locally, which provides a smooth surface over the entire substrate. Furthermore, only the material of the collar must be removed in the present method, resulting in a very low material removal.

Therefore, the substrate can be more often reused and recycled. The separate severing of the collar leads further to a very low total thickness variation of the recycled substrate. Due to the reduced material removal, the recycled substrate can be used over more recycling steps with an acceptable thickness and is therefore more stable resulting in a reduced risk of breaking of the substrate. The severing of the collar leads to a shortened treating of the substrate which enhances the productivity of recycling.

This method is particularly advantageous in recycling of substrates in which the interface material has been pre-weakened by an implantation step carried out before the separation step. With these substrates, the pre-weakened material can act as a predetermined breaking point at which the collar is removed from the surface.

According to claim 1, the separate step comprises directing a jet of water and/or air and/or fluid to the collar. By this method, the collar can be effectively removed by rinsing and/or spraying.

According to an advantageous variation of the invention, the jet can be directed from an interior of the surface outwardly to the collar. Thus, the jet is directed away to a region outwardly and removed collar pieces do not affect the surface of the substrate.

According to claim 1, the jet of water and/or air and/or another fluid impinges on the interface between the surface and the collar. This concentrates the energy of the jet on the interface and enables an abrupt removal of the collar from the surface.

According to claim 3, the separate step comprises directing a laser beam to the collar. The laser beam can attack the collar and remove it in an effective way.

According to claim 3, the laser beam at least impinges on the interface between the surface and the collar. The interface between the surface and the collar can be used as a break point resulting in an exceptional smoothness of the planarised surface. Preferably, the laser beam impinges from outside and/or from inside the substrate. This method offers the possibility to act on the collar from the inside and/or from the outside of the substrate which enhances the productivity of the removal of the collar.

In a further example of the invention, directing the laser beam comprises aligning the laser beam parallel to the surface of the wafer. This makes it possible to lead the laser beam directly to the interface resulting in a high efficacy of material removal.

According to a further favourable embodiment of the invention, aligning comprises aligning the laser beam parallel to the surface by a screen having a slit at the level of the interface and being near the edge of the substrate. By this method, the laser beam can be lead directly to the interface which leads to an efficient and accurate removal of the collar, preferably in one piece.

In a further advantageous embodiment, the substrate is rotating during the separate step. By this rotation, a device for a piecewise severing of the collar must only be placed in one position and during rotating of the substrate the device can act radially on the whole substrate.

According to claim 7, the separate step comprises applying a shock wave on a backside of a substrate. This shock wave induces frictional forces between the edges of the collar especially at the interface between the collar and the surface, leading to good piecewise severing of the collar, especially at the interface. The shock wave hat a particularly good removal effect due to its application on the backside of the substrate.

According to claim 8, the separate step comprises bombarding the collar with ions and/or ion clusters. They can be directed to the collar and bombard the collar with a high degree of energy causing a good severing of the collar.

According to claim 8, the collar is bombarded at said interface between the collar and the surface. The interface is very well suited for such a bombardment because it can act as a predetermined breaking point, offering a good homogeneity of the surface after severing of the collar. This method is particularly advantageous in the Smart-cut^{®} technology, where the interface material is pre-weakened and the bombardment of ions and/or ion clusters can remove the collar.

According to a favourable embodiment of the invention, bombarding comprises focussing an ion beam on the interface by a screen having a slit provided near the edge of the substrate. This method enables the ion beam to be directed precisely and with high energy on the interface resulting in a very effective removal of the collar from the surface.

In a further advantageous embodiment of the invention, the entire surface including the edge region is planarised after said separate step. This further planarisation results in a very smooth surface, especially at the region where the collar was situated on the surface. This method can further improve the total thickness variance of the recycled substrate.

In another favourable example of the invention, the surface including the edge region is thinned in the planarising step by about 0.2 µm. In this manner, a damaged area of the substrate resulting from an implantation step can be removed.

Embodiments of the present invention are described in the following description with reference to the accompanying figures, in which:
Fig. 1 shows a conventional Smart-cut^{®} process;
Fig. 2 shows the directing of a water jet or an air jet to the collar, according to a first embodiment of the present invention;
Fig. 3 shows the directing of a laser beam to the collar, according to a second embodiment of the present invention;
Fig. 4 shows the application of a shock wave on a backside of a substrate, according to a third embodiment of the present invention; and
Fig. 5 shows the bombarding of the collar with ions and/or ion clusters, according to a fourth embodiment of the present invention.

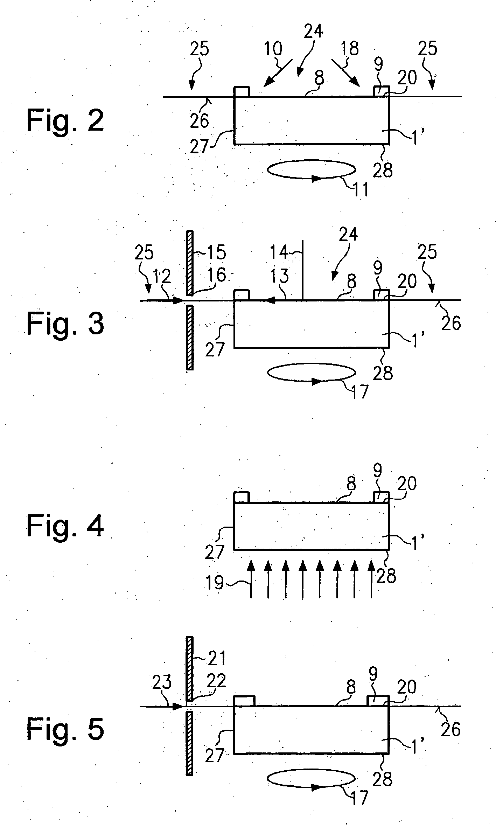

Figs. 2 to 5 respectively show a semiconductor substrate 1' in the form of a silicon wafer. Said wafer 1' is comparable to said delaminated wafer 1' shown in Fig. 1f which has been produced by the Smart-cut^{®} technology. But said wafers or substrates can also be preprocessed by using a different technology. Basically, all semiconductor substrates having at least a non-uniformity on the surface can be recycled with the method of the present invention. Typical materials are silicon in all modifications such as CZ-silicon, NPC-silicon, Epi-Silicon, FZ-silicon, germanium, sapphire, silicon carbide (SiC), A_{III}B_{V}-compounds such as Galliumarsenide (GaAs), Galliumnitride (GaN), Indiumphosphide (InP) and their alloys or Silicon Germanium (SiGe) and their oxides. The materials can be doped or undoped, insulators, semi-insulator materials or Epi-materials. Further, the treated substrates are not restricted to wafers. The substrate can have any form or size available in semiconductor technology.

It is very well known that silicon wafers 1' as shown in Fig. 2 to 5 basically have the shape of a thin circular plate. The Figs. show a vertical cross section through said rotationally symmetrical plate, including the diameter thereof. The wafer 1' has a collar 9 close to an edge 27 of the wafer. The collar 9 extends in a circle along the edge 27 similar to the circled plate shape of the wafer. In the case of a silicon wafer, the collar 9 consists of silicon and/or silicon dioxide.

On the upper side of the wafer 1', a plain surface 8 is provided surrounded by said collar 9. The surface 8 and the collar 9 form a profile of said substrate which has been created by the aforementioned method of the Smart-cut^{®} technology.

The prolongation of said surface 8 forms an interface 20 between said surface 8 and said collar 9. Said interface 20 has a weakened material stability due to the implantation step of the Smart-cut^{®} technology.

The collar 9 has a width of between about 1 and 5 mm and a thickness between approximately 10 nanometres and 2 micrometres measured from said interface 20. The collar 9 surrounds an interior 24 while the area outside the collar 9 is an outer region 25. Reference numeral 26 depicts the level of the interface 20 which is imaginable extended beyond the wafer 1'. Apart from said profile, the substrate is limited by the edges 27 and a backside 28 which is the lower side in Figs. 2 to 5.

The collar 9 as well as the surface 8 can be covered by a thin oxide film which can be removed prior to planarising the wafer 1'.

Fig. 2 shows a first embodiment of the present invention in which a jet of water 10 and/or a jet of air 18 is directed from the interior 24 of the surface 8 outwardly to the collar 9. The jets 10 and 18 can be applied alternatively, subsequently or simultaneously. They are respectively directed from an upper side at an angle outwardly to the collar 9 wherein they impinge at least on the interface 20 between the surface 8 and the collar 9. The use of a fluid has the advantage that the surface 8 is not damaged.

Instead of water or air, any suitable fluid can be used. Possible fluids are, for example, ultra pure water or inert gas like nitrogen or argon ions. The source of the fluid should be positioned close to the collar 9. The jet size should have a diameter of approximately 1 mm or less. Mechanical pressure can be added to help to cut the collar at the fragilised area of the interface 20.

The elliptical arrow 11 depicts the rotation of the wafer 1' about a centre axis perpendicular to the plate-like extension of the wafer. This enables a constant positioning of the jet source, preferably in the interior 24, which is permanently directed to a specific point of the interface 20. By rotation, the collar is subsequently severed piecewise along the circumference of the wafer 1'. During said separate step to remove the collar, the fragilised or pre-weakened area, i.e. the bottom of the collar 9, is under mechanical pressure.

After the removal of the collar follows a short final touch-polishing of the surface 8 with a conventional CMP process on the entire surface 8, including its edges. In this step about 0.2 µm of material is removed at most which amount corresponds approximately to the upper limit of a damaged area of the substrate, which has been formed by the implantation step of the Smart-cut^{®} technology. This polish eliminates defects resulting from the implantation step shown in Fig. 1 and provides a good TTV of the polished surface 8.

Fig. 3 shows a second embodiment of the present invention in which a laser beam 12,13 is used to sever the collar 9. Fig. 3 depicts a wafer with a collar 9 as described with respect to Fig. 2. Arrows 12 and 13 depict laser beams wherein the laser beam 12 is applied from outside the wafer 1 and laser beam 13 is applied from inside the wafer 1'. Said laser beams are aligned to be parallel to the surface 8 and impinge on the interface 20 between the surface 8 and the collar 9.

The laser source can be an Excimer laser releasing the excision energy through UF photons. A YAG (yttrium-aluminium garnet-laser with neodymium or carbon dioxide) could be used wherein frequencies can be intensified. The kind of laser depends on the material to remove.

A visual system is used to orientate the laser beam 12, 13 on the local fragilised area on the interface 20. A screen 15 with a slit 16 is provided on the side of the edge 27 of the wafer 1. A laser beam 12 is focussed by said slit 16 directly on the interface 20.

The laser beam 12, 13 can be brought onto the collar by means of fibre optics. In an alternative, a mirror 14 can be used. Said mirror is orientated perpendicular to the surface 8 in the centre thereof. It reflects the laser beam 13 from the interior parallel to the surface 8 on the interface 20.

Arrow 17 indicates the direction of rotation of the wafer 1' during a severing step, similar to the direction of rotation 11 shown in Fig. 2.

If the wafer 1' has been produced by said Smart-cut^{®} technology, the interface is a local fragilised or pre-weakened area. The laser beam 12, 13 is directly focussed on said interface 12. The laser piecewise cuts the collar 9 from the surface. Mechanical pressure can be additionally applied by an appropriate means which helps to break away the collar 9 which is pre-cut by said laser beam 12, 13. The surface is further treated with a final polishing similar to that of the first embodiment.

Fig. 4 shows a third embodiment of the present invention in which a shock wave 19 is applied to a backside 28 of the silicon wafer 1'. The silicon wafer 1' with the collar 9 has the same structure as explained with regard to Figs. 2 and 3. Identical reference numerals refer to identical parts as indicated in the corresponding previous description parts. The shock wave 19 can be applied by an energy impulse generating the shock wave with an amplitude suitable for splitting the collar 9 from the wafer 1' at the interface 20. The shock wave 19 can be produced by a single impulse or several repeated impulses. This method is especially advantageous if said interface zone is pre-fragilised, e.g. by the implantation of atomic species as in the Smart-cut^{®} technology.

In this embodiment, the shock wave 19 is applied only to separate the collar 9 from the wafer 1' into pieces, preferably at said interface 20. Even if the surface 8 has been produced by separation from another wafer, e.g. as described in WO 01/80308 A2, the separate step according to the present invention is specifically applied to remove the collar 9. Finally, the whole surface 8 is polished with a CMP process similar to that of the first embodiment.

Fig. 5 depicts a fourth embodiment of the present invention in which the collar 9 is bombarded with ions and/or ion clusters 23. Said beam of ion and/or ion clusters 23 is directed to the interface 20 between the collar 9 and the surface P. Said ion beam 23 is orientated parallel to said surface 8 of the wafer 1'.

The beam 23 is focussed by a screen 21 having a slit 22 provided near the edge 27 of the wafer 1'. The beam 23 of ions and/or ion clusters cuts the collar piecewise and severs same from the wafer 1'.

During the separate step for separating the collar 9, the wafer 1' can be rotated as indicated by the direction of rotation 17, which is about a vertical axis in the centre of the wafer 1', as described with respect to Fig. 2 and 3 above.

After said separate step for severing the collar of said surface 8, the entire surface 8 including the region near the edge is planarised in order to obtain a very smooth surface. In total, the method with the separate step for piecewise severing the collar from said surface provides a better total thickness variance of the recycled substrate and a better surface after the removal of the collar 9. In said separate step, the surface 8 is not specifically treated; only the collar is severed piecewise.

## Claims

1. A method for recycling a substrate (1'), especially a wafer, said substrate (1') having a separation profile including a surface (8) and a collar (9), wherein an interface (20), resulting from a previous implantation step and having a weakened material, is provided between said surface (8) and said collar (9), said separation profile resulting from a previous separation step, and is further planarised for obtaining a plane surface,
the method comprises a step of severing of the collar (9) from said surface (8) at said interface (20) in a separate step,
**characterized in that**
the separate step comprises directing a jet of water (10) and/or air (18), and/or another fluid to the collar (9) and at least impinging on the interface (20) between the surface (8) and the collar (9).

2. The method according to claim 1, wherein the jet is directed from an interior (24) of the surface (8) outwardly to the collar (9).

3. A method for recycling a substrate (1'), especially a wafer, said substrate (1') having a separation profile including a surface (8) and a collar (9), wherein an interface (20), resulting from a previous implantation step and having a weakened material, is provided between said surface (8) and said collar (9), said separation profile resulting from a previous separation step, and is further planarised for obtaining a plane surface,
the method comprises a step of severing of the collar (9) from said surface (8) at said interface (20) in a separate step,
**characterized in that**
the separate step comprises directing a laser beam (12, 13) to the collar (9) and at least impinging on the interface (20) between the surface (8) and the collar (9).

4. The method according to claim 3, wherein the laser beam impinges from outside (25) and/or from inside (24) the substrate (1).

5. The method according to claim 3 or 4, wherein directing the laser beam (12, 13) comprises aligning the laser beam parallel to the surface (8) of the substrate (1').

6. The method according to claim 5, wherein aligning comprises focusing the laser beam (12, 13) parallel to the surface (8) by a screen (15) having a slit (16) at the level (26) of the interface (20) and being near the edge (27) of the substrate (1').

7. A method for recycling a substrate (1'), especially a wafer, said substrate (1') having a separation profile including a surface (8) and a collar (9), wherein an interface (20), resulting from a previous implantation step and having a weakened material, is provided between said surface (8) and said collar (9), said separation profile resulting from a previous separation step, and is further planarised for obtaining a plane surface,
the method comprises a step of severing of the collar (9) from said surface (8) at said interface (20) in a separate step,
**characterized in that**
the separate step comprises applying a shock wave (19) on a back side (28) of the substrate (1') so as to separate the collar (9) from the substrate (1') at the interface (20) between the surface (8) and the collar (9).

8. A method for recycling a substrate (1'), especially a wafer, said substrate (1') having a separation profile including a surface (8) and a collar (9), wherein an interface (20), resulting from a previous implantation step and having a weakened material, is provided between said surface (8) and said collar (9), said separation profile resulting from a previous separation step, and is further planarised for obtaining a plane surface,
the method comprises a step of severing of the collar (9) from said surface (8) at said interface (20) in a separate step,
**characterized in that**
the separate step comprises bombarding the collar (9) with ions and/or ion clusters (23), at said interface (20) between the collar (9) and the surface (8).

9. The method according to claim 8, wherein bombarding comprises focusing an ion beam (23) on the interface (20) by a screens (21) having a slit (22), provided near the edge (27) of the substrate (1').

10. The method of at least one of the preceding claims, wherein the substrate (1') is rotating during the separate step.

11. The method according to at least one of the preceding claims, wherein the entire surface (8) including the edge region is planarised after said separate step.

12. The method according to claim 11, wherein the surface (8) including the edge region is thinned in the planarising step by about 0.2 µm.

## Patentansprüche

1. Verfahren zum Recyceln eines Substrats (1'), insbesondere einer Halbleiterscheibe, wobei das Substrat (1') ein Trennprofil mit einer Oberfläche (8) und einem Kragen (9) hat, wobei eine Grenzfläche (20), die sich aus einem vorhergehenden Implantationsschritt ergibt und ein geschwächtes Material aufweist, zwischen der Oberfläche (8) und dem Kragen (9) vorgesehen ist, wobei das Trennprofil sich aus einem vorhergehenden Trennschritt ergibt, und weiter eingeebnet wird, um eine ebene Oberfläche zu erhalten,
wobei das Verfahren einen Schritt des Abtrennens des Kragens (9) von der Oberfläche (8) an der Grenzfläche (20) in einem separaten Schritt umfasst,
**dadurch gekennzeichnet, dass**
der separate Schritt umfasst: Lenken eines Strahls aus Wasser (10) und/oder aus Luft (18) und/oder aus einem weiteren Fluid auf den Kragen (9) und Auftreffen lassen des Strahls zumindest auf der Grenzfläche (20) zwischen der Oberfläche (8) und dem Kragen (9).

2. Verfahren nach Anspruch 1, wobei der Strahl vom Inneren (24) der Oberfläche (8) nach außen zu dem Kragen (9) gelenkt wird.

3. Verfahren zum Recyceln eines Substrats (1'), insbesondere einer Halbleiterscheibe, wobei das Substrat (1') ein Trennprofil mit einer Oberfläche (8) und einem Kragen (9) hat, wobei eine Grenzfläche (20), die sich aus einem vorhergehenden Implantationsschritt ergibt und ein geschwächtes Material aufweist, zwischen der Oberfläche (8) und dem Kragen (9) vorgesehen ist, wobei das Trennprofil sich aus einem vorhergehenden Trennschritt ergibt, und weiter eingeebnet wird, um eine ebene Oberfläche zu erhalten,
wobei das Verfahren einen Schritt des Abtrennens des Kragens (9) von der Oberfläche (8) an der Grenzfläche (20) in einem separaten Schritt umfasst,
**dadurch gekennzeichnet, dass**
der separate Schritt umfasst: Lenken eines Laserstrahls (12, 13) zu dem Kragen (9) und Auftreffen lassen des Laserstrahls zumindest auf der Grenzfläche (20) zwischen der Oberfläche (8) und dem Kragen (9).

4. Verfahren nach Anspruch 3, wobei der Laserstrahl von außerhalb (25) und/oder von innerhalb (24) des Substrats (1) auftrifft.

5. Verfahren nach Anspruch 3 oder 4, wobei Lenken des Laserstrahls (12, 13) Ausrichten des Laserstrahls parallel zu der Oberfläche (8) des Substrats (1') umfasst.

6. Verfahren nach Anspruch 5, wobei Ausrichten Fokussieren des Laserstrahls (12, 13) parallel zu der Oberfläche (8) mittels eines Schirms (15) umfasst, der einen Schlitz (16) auf der Höhe (29) der Grenzfläche (20) hat und in der Nähe des Randes (27) des Substrats (1') liegt.

7. Verfahren zum Recyceln eines Substrats (1'), insbesondere einer Halbleiterscheibe, wobei das Substrat (1') ein Trennprofil mit einer Oberfläche (8) und einem Kragen (9) hat, wobei eine Grenzfläche (20), die sich aus einem vorhergehenden Implantationsschritt ergibt und ein geschwächtes Material aufweist, zwischen der Oberfläche (8) und dem Kragen (9) vorgesehen ist, wobei das Trennprofil sich aus einem vorhergehenden Trennschritt ergibt, und weiter eingeebnet wird, um eine ebene Oberfläche zu erhalten,
wobei das Verfahren einen Schritt des Abtrennens des Kragens (9) von der Oberfläche (8) an der Grenzfläche (20) in einem separaten Schritt umfasst,
**dadurch gekennzeichnet, dass**
der separate Schritt Einwirken mit einer Stoßwelle (19) auf eine Rückseite (28) des Substrats (1') derart umfasst, dass der Kragen (9) von dem Substrat (1') an der Grenzfläche (20) zwischen der Oberfläche (8) und dem Kragen (9) abgetrennt wird.

8. Verfahren zum Recyceln eines Substrats (1'), insbesondere einer Halbleiterscheibe, wobei das Substrat (1') ein Trennprofil mit einer Oberfläche (8) und einem Kragen (9) hat, wobei eine Grenzfläche (20), die sich aus einem vorhergehenden Implantationsschritt ergibt und ein geschwächtes Material aufweist, zwischen der Oberfläche (8) und dem Kragen (9) vorgesehen ist, wobei das Trennprofil sich aus einem vorhergehenden Trennschritt ergibt, und weiter eingeebnet wird, um eine ebene Oberfläche zu erhalten,
wobei das Verfahren einen Schritt des Abtrennens des Kragens (9) von der Oberfläche (8) an der Grenzfläche (20) in einem separaten Schritt umfasst,
**dadurch gekennzeichnet, dass**
der separate Schritt Beschießen des Kragens (9) mit Ionen und/oder Ionenclustern (23) an der Grenzfläche (20) zwischen dem Kragen (9) und der Oberfläche (8) umfasst.

9. Verfahren nach Anspruch 8, wobei Beschießen umfasst: Fokussieren eines lonenstrahls (23) auf die Grenzfläche (20) mittels eines Schirms (21), der einen Schlitz (22) aufweist und in der Nähe des Rands (27) des Substrats (1') vorgesehen ist.

10. Verfahren nach einem der vorhergehenden Ansprüche, wobei das Substrat (1') während des separaten Schritts gedreht wird.

11. Verfahren nach einem der vorhergehenden Ansprüche, wobei die gesamte Oberfläche (8) einschließlich des Randgebiets nach dem separaten Schritt eingeebnet wird.

12. Verfahren nach Anspruch 11, wobei die Oberfläche (8) einschließlich des Randgebiets in dem Einebnungsschritt um ungefähr 0,2 µm gedünnt wird.

## Revendications

1. Procédé de recyclage d'un substrat (1'), en particulier d'une plaquette, ledit substrat (1') présentant un profil de séparation qui inclut une surface (8) et un collier (9), dans lequel une interface (20), résultant d'une étape d'implantation antérieure et comportant un matériau affaibli, est pourvue entre ladite surface (8) et ledit collier (9), ledit profil de séparation résultant d'une étape de séparation antérieure, et est en outre aplanie pour obtenir une surface plane,
le procédé comprend une étape de disjonction du collier (9) de ladite surface (8) à ladite interface (20) dans une étape séparée,
**caractérisé en ce que**
l'étape séparée comprend la direction d'un jet d'eau (10), d'air (18) et/ou d'un autre fluide sur le collier (9) et impactant au moins l'interface (20) entre la surface (8) et le collier (9).

2. Procédé selon la revendication 1, dans lequel le jet est dirigé depuis l'intérieur (24) de la surface (8) vers l'extérieur sur le collier (9).

3. Procédé de recyclage d'un substrat (1'), en particulier d'une plaquette, ledit substrat (1') présentant un profil de séparation qui inclut une surface (8) et un collier (9), dans lequel une interface (20), résultant d'une étape d'implantation antérieure et comportant un matériau affaibli, est pourvue entre ladite surface (8) et ledit collier (9), ledit profil de séparation résultant d'une étape de séparation antérieure, et est en outre aplanie pour obtenir une surface plane,
le procédé comprend une étape de disjonction du collier (9) de ladite surface (8) à ladite interface (20) dans une étape séparée,
**caractérisé en ce que**
l'étape séparée comprend la direction d'un faisceau laser (12, 13) sur le collier (9) et impactant au moins l'interface (20) entre la surface (8) et le collier (9).

4. Procédé selon la revendication 3, dans lequel le faisceau laser impacte le substrat (1) depuis l'extérieur (25) et/ou depuis l'intérieur (24).

5. Procédé selon la revendication 3 ou 4, dans lequel la direction du faisceau laser (12, 13) comprend l'alignement du faisceau laser parallèlement à la surface (8) du substrat (T).

6. Procédé selon la revendication 5, dans lequel l'alignement comprend la focalisation du faisceau laser (12, 13) parallèlement à la surface (8) à l'aide d'un écran (15) comportant une fente (16) au niveau (26) de l'interface (20) et proche du bord (27) du substrat (1').

7. Procédé de recyclage d'un substrat (T), en particulier d'une plaquette, ledit substrat (1') présentant un profil de séparation qui inclut une surface (8) et un collier (9), dans lequel une interface (20), résultant d'une étape d'implantation antérieure et comportant un matériau affaibli, est pourvue entre ladite surface (8) et ledit collier (9), ledit profil de séparation résultant d'une étape de séparation antérieure, et est en outre aplanie pour obtenir une surface plane,
le procédé comprend une étape de disjonction du collier (9) de ladite surface (8) à ladite interface (20) dans une étape séparée,
**caractérisé en ce que**
l'étape séparée comprend l'application d'une onde de choc (19) sur une face arrière (28) du substrat (1') de manière à séparer le collier (9) du substrat (1') à l'interface (20) entre la surface (8) et le collier (9).

8. Procédé de recyclage d'un substrat (T), en particulier d'une plaquette, ledit substrat (1') présentant un profil de séparation qui inclut une surface (8) et un collier (9), dans lequel une interface (20), résultant d'une étape d'implantation antérieure et comportant un matériau affaibli, est pourvue entre ladite surface (8) et ledit collier (9), ledit profil de séparation résultant d'une étape de séparation antérieure, et est en outre aplanie pour obtenir une surface plane,
le procédé comprend une étape de disjonction du collier (9) de ladite surface (8) à ladite interface (20) dans une étape séparée,
**caractérisé en ce que**
l'étape séparée comprend le bombardement du collier (9) avec des ions et/ou des groupes d'ions (23), sur ladite interface (20) entre le collier (9) et la surface (8).

9. Procédé selon la revendication 8, dans lequel le bombardement comprend la focalisation d'un faisceau d'ions (23) sur l'interface (20) à l'aide d'un écran (21) comportant une fente (22), pourvue près du bord (27) du substrat (T).

10. Procédé selon au moins l'une des revendications précédentes, dans lequel le substrat (T) est en rotation durant l'étape séparée.

11. Procédé selon au moins l'une des revendications précédentes, dans lequel l'entièreté de la surface (8) incluant la zone de bord est aplanie après ladite étape séparée.

12. Procédé selon la revendication 11, dans lequel la surface (8) incluant la zone de bord est amincie à l'étape d'aplanissement d'environ 0,2 µm.
